# EUROPÄISCHE PATENTSCHRIFT

(11) **EP 1 466 370 B1**
(45) Veröffentlichungstag und Bekanntmachung des Hinweises auf die Patenterteilung: **18.02.2015**
(21) Anmeldenummer: 02791621.2
(22) Anmeldetag: 10.12.2002
(51) Int. Cl.: H01L 29/792, H01L 21/8246, H01L 27/115, H01L 29/66

(54) **VERFAHREN ZUR HERSTELLUNG EINER NICHTFLÜCHTIGEN DUALBIT HALBLEITER-SPEICHERZELLE**
METHOD OF FORMING NON-VOLATILE DUAL BIT SEMICONDUCTOR MEMORY CELL
PROCEDE DE FORMATION D'UNE CELLULE DE MEMOIRE NON VOLATILE A SEMI-CONDUCTEUR A DEUX BITS

(30) Priorität: 15.01.2002 DE 10201304
(43) Veröffentlichungstag der Anmeldung: 13.10.2004
(73) Patentinhaber: Infineon Technologies AG, 85579 Neubiberg (DE)
(72) Erfinder: TEMPEL, Georg, D-01277 Dresden (DE); SCHULER, Franz, B-3000 Leuven (BE)
(74) Vertreter: Kindermann, Peter
(86) Internationale Anmeldenummer: PCT/DE2002/004522
(87) Internationale Veröffentlichungsnummer: WO 2003/061014

(56) Entgegenhaltungen:
- EP-A2- 1 170 800
- WO-A-01/17030
- WO-A1-01/18878
- WO-A2-02/11145
- US-A1- 2002 084 484
- US-B1- 6 271 090

## Beschreibung

Die vorliegende Erfindung bezieht sich auf ein Verfahren zur Herstellung einer nichtflüchtigen Halbleiter-Speicherzelle und insbesondere auf ein Herstellungsverfahren einer sogenannten Dualbit-EEPROM-Speicherzelle.

Aus der Druckschrift WO 02/11145 A ist eine nichtflüchtige Halbleiter-Speicherzelle mit in einem Substrat ausgebildeten Sourcegebiet, Draingebiet und Kanalgebiet bekannt, wobei zum Ausbilden eines ersten und eines zweiten lokal begrenzten Speicherorts an der Oberfläche des Kanalgebiets eine erste Isolationsschicht, darauf eine elektrisch nicht leitende Ladungsspeicherschicht und darauf eine zweite Isolationsschicht ausgebildet sind. Die elektrisch nicht leitende Ladungsspeicherschicht weist hierbei eine Unterbrechung auf, wobei eine elektrisch leitende Steuerschicht zumindest innerhalb der Unterbrechung ausgebildet ist.

Als Alternative zu herkömmlichen mechanischen Speichereinrichtungen haben sich in letzter Zeit nichtflüchtige Halbleiter-Speichereinrichtungen mit nichtflüchtigen Halbleiter-Speicherzellen wie beispielsweise FLASH-, EPROM-, EEPROM-, FPGA-Speicherzellen und dergleichen immer mehr durchgesetzt. Derartige wieder beschreibbare nichtflüchtige Halbleiter-Speicherzellen können über einen langen Zeitraum und ohne Verwendung einer Spannungsversorgung Daten abspeichern.

Üblicherweise bestehen derartige Halbleiter-Speicherzellen aus einem Halbleitersubstrat, einer isolierenden Tunnelschicht, einer Speicherschicht, einer isolierenden dielektrischen Schicht und einer leitenden Steuerschicht. Zur Speicherung von Informationen werden Ladungen von einem Halbleitersubstrat in die ladungsspeichernde Schicht eingebracht. Verfahren zum Einbringen der Ladungen in die Speicherschicht sind beispielsweise Injektion heißer Ladungsträger und Fowler-Nordheim-Tunneln.

Bei der Realisierung von derartigen nichtflüchtigen Halbleiter-Speicherzellen sind insbesondere ein Informationsgehalt pro Flächeneinheit, die Ladungshalteeigenschaften sowie die Betriebsspannungen zum Lesen und Programmieren von Bedeutung. Zur Verbesserung einer Ladungshaltezeit wurden hierbei insbesondere zunehmend nichtflüchtige Halbleiter-Speicherzellen mit elektrisch nicht leitenden Ladungsspeicherschichten verwendet, wodurch auch bei teilweise unzureichenden Isolationsschichten ein Leckstrom verhindert und dadurch die Ladungshalteeigenschaften (charge retention) verbessert werden können.

Darüber hinaus wurden sogenannte Multi-Bit-Halbleiter-Speicherzellen entwickelt, die eine Vielzahl von Informationsgehalten bzw. Bits in einer Speicherzelle realisieren können. Auf diese Weise konnte der Informationsgehalt pro Flächeneinheit wesentlich verbessert werden.

Die vorliegende Erfindung bezieht sich insbesondere auf ein Verfahren zur Herstellung einer Dualbit-Halbleiter-Speicherzelle mit der zwei Bits nichtflüchtig gespeichert werden können.

Eine derartige Dualbit-Halbleiter-Speicherzelle ist beispielsweise aus der Druckschrift US 6,011,725 bekannt und wird nachfolgend mittels Figur 1 beschrieben.

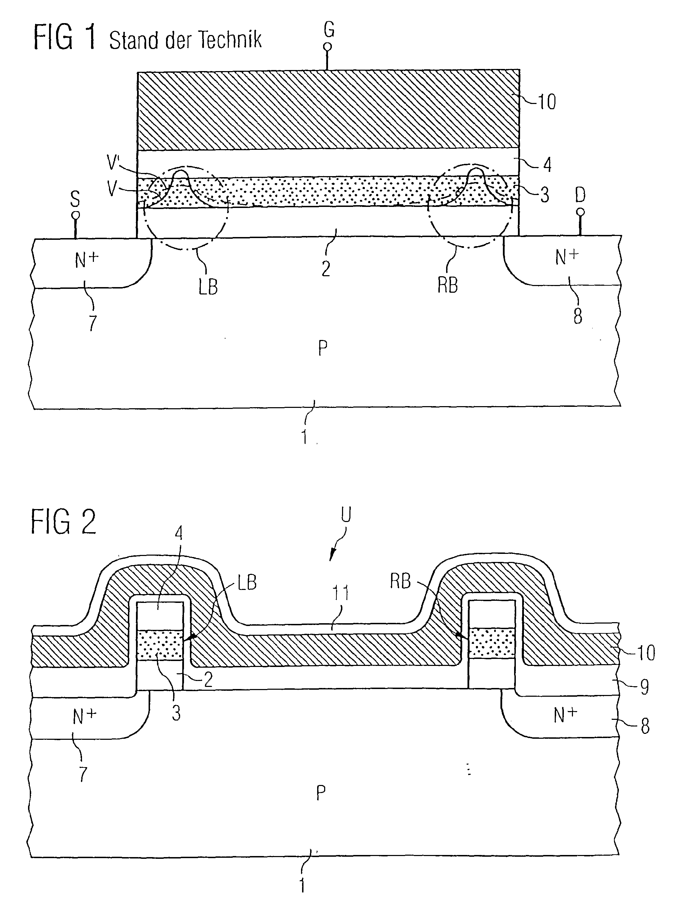

Gemäß Figur 1 besitzt eine derartige Zwei-Bit-EEPROM-Speicherzelle ein Halbleitersubstrat 1, welches beispielsweise p-dotiert ist und welches ein n⁺-dotiertes Sourcegebiet 7 und Draingebiet 8 mit dazugehörigen Source- und Drainanschlüssen S und D aufweist. Es sei darauf hingewiesen, dass in einer derartigen Zelle ein symmetrischer Aufbau verwendet wird, weshalb die Begriffe Source und Drain nicht unbedingt aussagekräftig sind. Tatsächlich kann beispielsweise das Sourcegebiet 7 auch als Draingebiet und das Draingebiet 8 auch als Sourcegebiet angeschaltet werden.

Gemäß Figur 1 definieren die Source- und Draingebiete 7 und 8 ein dazwischen liegendes Kanalgebiet. An der Oberfläche dieses Kanalgebiets befindet sich eine erste Isolationsschicht 2, eine elektrisch nicht leitende Ladungsspeicherschicht 3, eine zweite Isolationsschicht 4 und eine elektrisch leitende Steuerschicht 10, die einen Gateanschluss G aufweist. Als elektrisch nicht leitende Ladungsspeicherschicht 3 wird gemäß Figur 1 Siliziumnitrid verwendet. Zum Programmieren, d.h. Schreiben und Löschen dieser herkömmlichen nichtflüchtigen Halbleiter-Speicherzelle wird im Wesentlichen eine Injektion heißer Ladungsträger durchgeführt, wobei zum Schreiben beispielsweise heiße Elektronen drainseitig in die Ladungsspeicherschicht 3 und zum Löschen heiße Löcher drainseitig injiziert werden. Da es sich um eine symmetrische Dualbit-Speicherzelle handelt, können in gleicher Weise auch sourceseitig Ladungsträger in die Ladungsspeicherschicht 3 injiziert werden, wobei jedoch das Sourcegebiet 7 als Drain geschaltet ist. Hinsichtlich des Verfahrens zum Lesen, Schreiben und Löschen einer derartigen Speicherzelle wird explizit auf die Druckschrift US 6,011,725 verwiesen.

Aus der Druckschrift WO-A-0117030 ist eine nichtflüchtige Halbleiter-Speicherzelle zum Speichern von zwei Bits bekannt, wobei in einem Substrat ein Sourcegebiet, ein Draingebiet und ein dazwischen liegendes Kanalgebiet ausgebildet ist. Insbesondere sind hierbei L-förmige Speicher-Schichtstapel seitlich neben einer elektrisch leitenden Steuerschicht ausgebildet, die sich neben dem Kanalgebiet über die Source- und Draingebiete, das Substrat und sogar darüber hinaus erstrecken.

Obwohl man bei einer derartigen herkömmlichen Halbleiter-Speicherzelle bereits außerordentlich hohe Ladungshalteeigenschaften bei relativ geringen Programmierspannungen erhält, haben sich jedoch Nachteile gezeigt, die insbesondere bei einer mehrfachen Programmierung über einen langen Zeitraum von Bedeutung sind. Dies liegt insbesondere daran, dass die zum Löschen notwendigen heißen Löcher in der Regel mittels Lawineneffekt im Feld der p-n Diode erzeugt werden und daher nicht exakt an die gleiche Stelle in der Ladungsspeicherschicht 3 fallen wie die beim Schreiben eingebrachten heißen Elektronen. Für einen rechts angeordneten Speicherort RB (right bit) ergibt sich in gleicher Weise wie für einen sourceseitig angeordneten linken Speicherort LB (left bit) das Problem, dass die Elektronen und Löcher nicht exakt an der gleichen Stelle eingebracht werden und folglich eine leichte Ladungsverschiebung stattfindet. Diese ungenaue Kompensation führt in der Regel zu Schwellwertverschiebungen in der Speicherzelle und damit zu Lesestromänderungen. Dies wiederum verursacht eine erhöhte Ungenauigkeit in einer nicht dargestellten Auswerteschaltung.

Ein weiterer Punkt, wodurch die Ladungshalteeigenschaften dieser herkömmlichen Halbleiter-Speicherzelle negativ beeinflusst werden, liegt in der Tatsache begründet, dass, obwohl die Ladungsspeicherschicht 3 elektrisch nicht leitend ist, dennoch eine geringe Ladungsbewegung stattfindet. Diese Ladungsbewegung innerhalb der Ladungsspeicherschicht 3 basiert vor allem auf Drift- und Diffusionsvorgängen, die zu einer langsamen Umverteilung der Ladungen in der Ladungsspeicherschicht 3 führen. Gemäß Figur 1 ist beispielsweise eine durchgezogene Ladungsverteilungskurve V dargestellt, wie sie sich kurz nach dem Einschreiben von beispielsweise Elektronen an den lokalen Speicherorten LB und RB ergibt. Auf Grund von Drift- und Diffusionsvorgängen verändert sich jedoch diese Verteilung V, wobei sich nach Ablauf einer vorbestimmten Zeit die gestrichelt dargestellte verbreiterte Verteilungskurve V' in der Ladungsspeicherschicht 3 einstellt. Dadurch wird jedoch die in den lokalen Speicherorten LB und RB abgelegte Ladungsdichte verringert. Durch das Umverteilen der Ladungen innerhalb der Ladungsspeicherschicht 3 wird die Schwellenspannung der Halbleiter-Speicherzelle verändert, was wiederum zu einem Informationsverlust oder zumindest zu erhöhten Anforderungen in der nicht dargestellten Auswerteschaltung führt.

Ferner sind aus der Druckschrift US-B1-6271090 eine alternative Dual-Bit-Speicherzelle sowie ein zugehöriges Herstellungsverfahren bekannt, wobei als Ladungsspeicherschicht eine elektrisch leitende Schicht verwendet wird. Zur Realisierung der Speicherfähigkeit von 2 Bits wird hierbei die elektrisch leitende Ladungsspeicherschicht in zwei voneinander isolierte Speicherorte aufgeteilt, die lokal begrenzt an der Oberfläche des Kanalgebietes ausgebildet sind.

Aus der Druckschrift US 2002/0084484 A1 ist ein weiteres herkömmliches Verfahren zur Herstellung von nichtflüchtigen Halbleiter-Speicherzellen bekannt, wobei jedoch kein Ausbilden von lokal begrenzten Schichtstapeln offenbart ist und folglich auch keine Seitenwandisolationen zur Verhinderung der Drift- und Diffusionsvorgänge in der Ladungsspeicherschicht bekannt oder nahegelegt sind.

Schließlich ist aus der Druckschrift EP 1 170 800 A2 ein Verfahren zur Herstellung von nichtflüchtigen Halbleiter-Speicherzellen bekannt, bei dem lokal begrenzte Schichtstapel erzeugt werden. Diese enthalten jedoch z.B. ein jeweiliges Steuer-Gate.

Der Erfindung liegt daher die Aufgabe zu Grunde, ein Verfahren zur Herstellung einer nichtflüchtigen Halbleiter-Speicherzelle zu schaffen, bei dem man verbesserte Ladungshalteeigenschaften erhält.

Erfindungsgemäß wird diese Aufgabe durch die Maßnahmen des Patentanspruchs 1 gelöst.

Insbesondere durch die Verwendung von lokal isolierten nicht leitenden Ladungsspeicherschichten bzw. einer elektrisch nicht leitenden Ladungsspeicherschicht, die zum Ausbilden dieser lokal begrenzten Speicherorte eine Unterbrechung aufweist, kann zum einen eine Umverteilung auf Grund der vorstehend beschriebenen Drift- und Diffusionsvorgänge in der Ladungsspeicherschicht zuverlässig verhindert werden. Darüber hinaus können die unterschiedlichen Einbringgenauigkeiten von Löchern und Elektronen in die Speicherschicht kompensiert werden, da die Ladungsspeicherschicht nur noch örtlich scharf begrenzt vorhanden ist. Das Einbringen einer dritten Isolationsschicht im Bereich zwischen den lokal begrenzten Speicherorten bzw. im Bereich der Unterbrechung kann insbesondere bei hochintegrierten Schaltungen dadurch die elektrischen Eigenschaften verbessern.

In den Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben. Es zeigen:
Figur 1 eine vereinfachte Schnittansicht einer Halbleiter-Speicherzelle gemäß dem Stand der Technik;
Figur 2 eine vereinfachte Schnittansicht einer nach dem erfindungsgemäßen Verfahren hergestellten nichtflüchtigen Halbleiter-Speicherzelle; und
Figuren 3A bis 3G-II vereinfachte Schnittansichten zur Veranschaulichung des erfindungsgemäßen Verfahrens.

Figur 2 zeigt eine vereinfachte Schnittansicht einer nach dem erfindungsgemäßen Verfahren hergestellten nichtflüchtigen Halbleiter-Speicherzelle, wobei gleiche Bezugszeichen gleiche oder ähnliche Elemente bzw. Schichten bezeichnen wie in Figur 1 und auf eine wiederholte Beschreibung nachfolgend verzichtet wird.

Die nachfolgend beschriebene Dualbit-EEPROM-Speicherzelle entspricht insbesondere hinsichtlich des Verfahrens zum Schreiben, Lesen und Löschen von Informationen der Dualbit-Speicherzelle gemäß Druckschrift US 6,011,725, weshalb an dieser Stelle ausdrücklich auf das in dieser Druckschrift offenbarte Verfahren verwiesen wird und auf eine wiederholte Beschreibung verzichtet wird.

Gemäß Figur 2 besteht die als Dualbit-EEPROM bezeichnete nichtflüchtige Halbleiter-Speicherzelle aus einem Substrat 1, in dem ein Sourcegebiet 7, ein Draingebiet 8 und ein dazwischen liegendes Kanalgebiet vergleichbar zu einem herkömmlichen Feldeffekttransistor ausgebildet ist. Beispielsweise besteht das Substrat 1 aus einem p-dotierten Halbleitermaterial wie z.B. Silizium. Bei der dargestellten NMOS-Speicherzelle sind die Source- und Draingebiete beispielsweise n⁺-dotiert. An der Oberfläche des Substrats 1 befindet sich zumindest an einem ersten lokal begrenzten Speicherort LB (left bit) und einem zweiten lokal begrenzten Speicherort RB (right bit) jeweils eine erste Isolationsschicht 2 bzw. ein Dielektrikum wie z.B. SiO₂. Darüber liegend befindet sich eine elektrisch nicht leitende Ladungsspeicherschicht 3, die zum eigentlichen Speichern der eingebrachten Ladungen verwendet wird. Diese elektrisch nicht leitende Ladungsspeicherschicht 3 besteht wiederum aus einem Dielektrikum wie z.B. Si₃N₄ oder sogenanntes "silicon rich oxid" Si₂₊ₓO auf. An der Oberfläche dieser Ladungsspeicherschicht 3 befindet sich an den lokal begrenzten Speicherorten LB und RB ferner eine zweite Isolationsschicht 4 aus wiederum einem Dielektrikum wie z.B. SiO₂. Wie bei der herkömmlichen Dualbit-Halbleiter-Speicherzelle sind demzufolge sourceseitig ein erster lokaler Speicherort LB (left bit) und drainseitig ein zweiter lokaler Speicherort RB (right bit) ausgebildet, die einen Stromfluss im Kanalgebiet bei Anlegen vorbestimmter Spannungen maßgeblich beeinflussen und somit zum Speichern von Daten, d.h. zwei Bits, geeignet sind.

Gegenüber der herkömmliche Halbleiter-Speicherzelle ist nunmehr jedoch die elektrisch nicht leitende Ladungsspeicherschicht 3 nicht durchgehend miteinander verbunden, sondern unterbrochen. Durch diese Unterbrechung bzw. Lücke U in der elektrisch nicht leitenden Ladungsspeicherschicht 3 wird sourceseitig ein erster lokal begrenzter Speicherort LB und drainseitig ein zweiter lokal begrenzter Speicherort RB vollkommen isoliert ausgebildet, wodurch die eingangs beschriebenen Drift- und Diffusionsvorgänge nicht zu einem Datenverlust führen können. Die Ladungsdichte in den lokal begrenzten Speicherorten LB und RB bleibt somit unverändert, weshalb man hervorragende Ladungshalteeigenschaften erhält.

Darüber hinaus werden jedoch durch die Ausbildung der lokal begrenzten Speicherorte LB und RB die elektrischen Eigenschaften der nichtflüchtigen Halbleiter-Speicherzelle verbessert. Wie eingangs bereits beschrieben wurde, erfolgt das Beschreiben der Speicherorte bzw. das Einbringen von Ladungen in die Speicherorte durch Injektion heißer Ladungsträger und wie beispielsweise in diesem Fall durch Injektion von Elektronen, welche im Kanalgebiet derart beschleunigt werden, dass sie die Energiebarriere der ersten Isolationsschicht 2 überwinden können und in die elektrisch nicht leitende Ladungsspeicherschicht 3 gelangen. Andererseits erfolgt jedoch das Löschen dieser Daten durch eine Kompensation der eingebrachten Ladungen mit entsprechend entgegengesetzten Ladungen. Beispielsweise werden zum Löschen heiße Löcher in die lokal begrenzten Speicherorte LB und RB injiziert. Da jedoch die Erzeugung von heißen Löchern üblicherweise über einen Lawineneffekt im pn-Dioden Bereich an Drain respektive Source erfolgt, ist der genaue Ort, in dem die Löcher letztendlich in der Ladungsspeicherschicht 3 zu liegen kommen nur sehr schwer vorher zu bestimmen und unterscheidet sich in der Regel von den Orten der Elektronen. Diese sich aus der Programmierung ergebende Ungenauigkeit wird erfindungsgemäß durch die lokal begrenzten Speicherorte LB und RB kompensiert, da auch bei einem sehr ungenauen Löschvorgang, der beispielsweise versetzt zur Verteilungsdichte der Elektronen erfolgt, diese unberücksichtigt bleiben und somit keinen negativen Einfluss beispielsweise auf die Schwellwertspannungen der Speicherzelle haben. Lediglich die tatsächlich in die lokal begrenzten Speicherorte LB und RB eingebrachten Löcher sind für eine Kompensation der Elektronen wirksam. Somit verbessern sich nicht nur die Ladungshalteeigenschaften, sondern auch die grundsätzlichen elektrischen Eigenschaften der nichtflüchtigen Halbleiter-Speicherzelle. Insbesondere die Veränderung der Schwellspannungen nach wiederholtem Schreib- und Löschvorgängen wird deutlich reduziert gegenüber dem Standardfall. Da die Ladungsspeicherbereiche nun auf LB und RB beschränkt sind, bestehen nunmehr geringere Anforderungen an die genaue Überlagerung beider Ladungsverteilungen. Ein weiterer Vorteil ist somit eine vereinfachte Entwicklung der pn-Diode und eine weniger kritische Fertigbarkeit.

Vorzugsweise besitzt die erste Isolationsschicht 2 eine Dicke, die größer ist als eine für ein jeweiliges Material notwendige Dicke für direktes Tunneln. Damit können Ladungsverluste auf Grund von direktem Tunneln zuverlässig verhindert werden. Gleiches gilt auch für die zweite Isolationsschicht 4, die sich oberhalb der Ladungsspeicherschicht 3 befindet. Gemäß Figur 2 besitzt nicht nur die elektrisch nicht leitende Ladungsspeicherschicht 3 eine Unterbrechung U, sondern auch die erste und zweite Isolationsschicht 2 und 4. Dadurch ergeben sich an den lokal begrenzten Speicherorten LB und RB lokal sehr begrenzte Schichtstapel, wobei der übrige Bereich insbesondere an der Oberfläche des Kanalgebiets frei von diesen Schichten ist. Gemäß Figur 2 befindet sich folglich eine dritte Isolationsschicht 9, die wiederum ein Dielektrikum wie z.B. SiO₂ aufweist an der Oberfläche des Substrats 1 bzw. dem lokal begrenzten Schichtstapel bestehend aus den Schichten 2, 3 und 4. An der Oberfläche dieser dritten Isolationsschicht 9 ist eine elektrisch leitende Steuerschicht 10 ausgebildet, wodurch die Lücke bzw. die Unterbrechung U zwischen den lokal begrenzten Speicherorten bzw. den Source- und Draingebieten 7 und 8 zumindest teilweise aufgefüllt ist. Optional kann eine vierte Isolationsschicht 11 an der Oberfläche der elektrisch leitenden Steuerschicht 10 ausgebildet werden, wobei beispielsweise ein Postoxid verwendet wird.

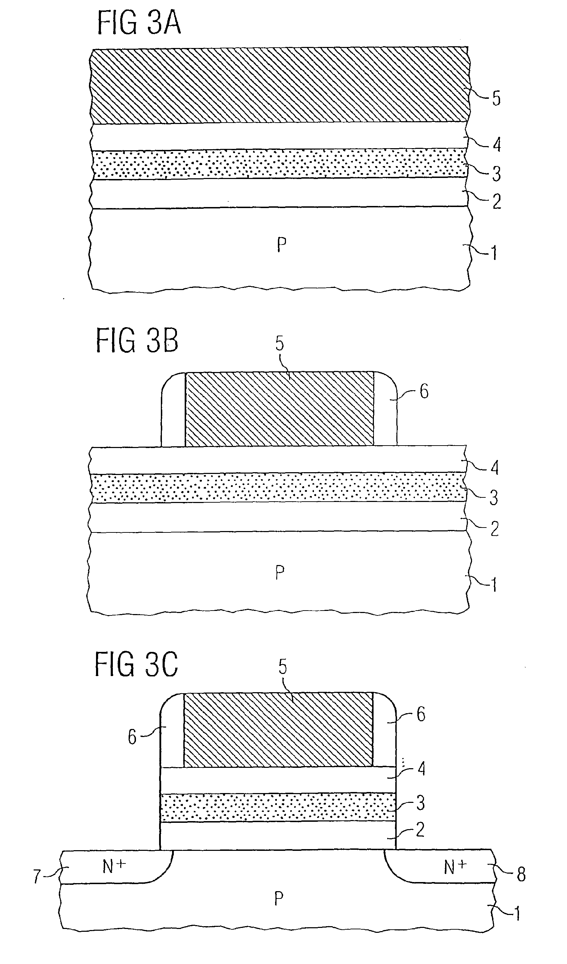

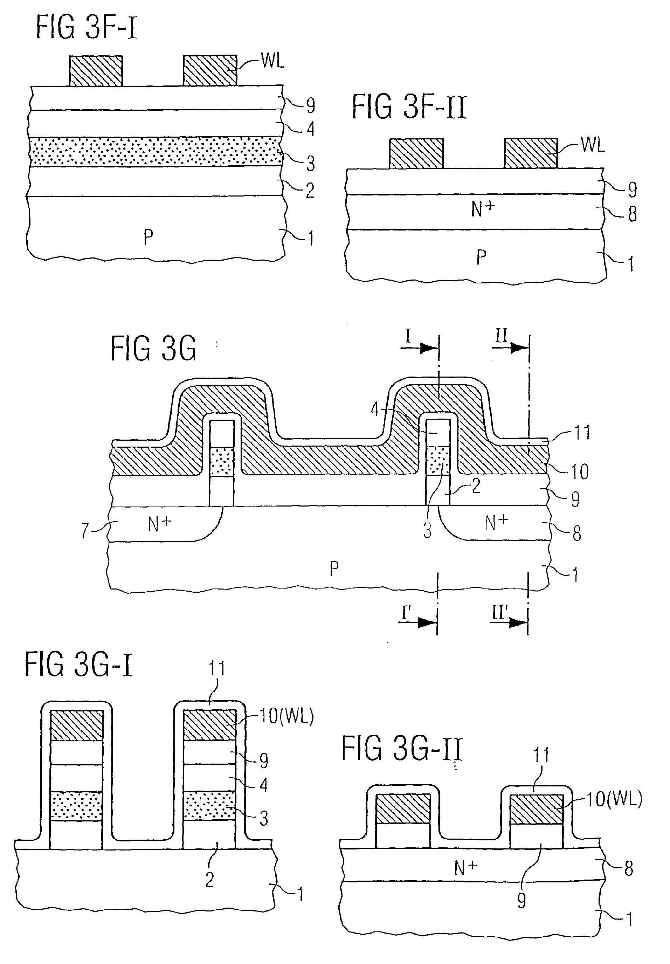

Nachfolgend wird ein Verfahren zur Herstellung der in Figur 2 dargestellten nichtflüchtigen Halbleiter-Speicherzelle anhand von Figuren 3A bis 3G-II beschrieben, wobei gleiche Bezugszeichen gleiche oder entsprechende Schichten bezeichnen und auf eine wiederholte Beschreibung nachfolgend verzichtet wird.

Gemäß Figur 3A werden zunächst auf einem Substrat 1, welches beispielsweise ein p-dotiertes Silizium-Halbleitersubstrat aufweist, eine erste Isolationsschicht 2, eine elektrisch nicht leitende Ladungsspeicherschicht 3, eine zweite Isolationsschicht 4 und eine Maskenschicht 5 ausgebildet. Zur Vermeidung von direkten Tunneleffekten besteht die erste Isolationsschicht aus einer ca. 8 bis 10 nm dicken SiO₂-Schicht. Direktes Tunneln tritt für SiO₂ typischerweise bei Schichtdicken kleiner 4 bis 6 nm auf. Die elektrisch nicht leitende Ladungsspeicherschicht besteht aus einer einigen nm dicken Si₃N₄-Schicht, kann jedoch auch sogenanntes "silicon rich oxide" d.h. SiₓO_{y} aufweisen. Für die zweite Isolationsschicht 4 wird beispielsweise 6 bis 10 nm dickes Siliziumdioxid verwendet, wodurch auch in dieser Richtung ein direktes Tunneln verhindert wird. Die Maskenschicht 5 besteht beispielsweise aus einem in einem jeweiligen Standardprozess vorliegenden Material, wie z.B. Polysilizium.

Gemäß Figur 3B wird in einem nachfolgenden Schritt eine Strukturierung der Maskenschicht 5 beispielsweise durch herkömmliche fotolithographische oder sonstige Verfahren durchgeführt und anschließend eine Zwischenschicht ausgebildet. Diese Zwischenschicht besteht beispielsweise aus einer konform abgeschiedenen Si₃N₄-Schicht die anschließend in einem herkömmlichen Rückätzschritt zur Herstellung der in Figur 3B dargestellten Seitenwandschichten bzw. Spacer 6 verwendet wird.

Zur Ausbildung der vorstehend beschriebenen Schichten 2 bis 6 sind alle für ein jeweiliges Material bekannten Verfahren zu verwenden, wie z.B. CVD (chemical vapor deposition), , epitaktische Verfahren und/oder thermische Oxidation.

Gemäß Figur 3C wird nunmehr anhand der strukturierten Maskenschicht 5 und der daran ausgebildeten Seitenwandschichten bzw. Spacer 6 zumindest die zweite Isolationsschicht 4 und die Ladungsspeicherschicht 3 entfernt und anschließend beispielsweise mittels Ionenimplantation die Source- und Draingebiete 7 und 8 selbstjustierend im Substrat 1 ausgebildet. In diesem Fall dient die erste Isolationsschicht 2 als Streumaterial bzw. Streuoxid zur Vermeidung von sogenannten "channeling-Effekten".

In gleicher Weise können jedoch die n⁺-dotierten Source- und Draingebiete auch durch unmittelbare Implantation in das Halbleitersubstrat 1 durchgeführt werden, wobei auch die erste Isolationsschicht 2 bei der Strukturierung unter Verwendung der strukturierten Maskenschicht 5 und der Seitenwandschicht 6 entfernt wird. Selbstverständlich können auch sogenannte pocket-Implantationen eingefügt werden. Die Sourceund Draingebiete 7 und 8 realisieren gleichzeitig auch die Bitleitungen der nichtflüchtigen Halbleiter-Speicherzelle oder zumindest die Anschlussgebiete für die Bitleitungen.

Die Herstellungsverfahren zum Strukturieren und Entfernen der vorstehend beschriebenen Schichten entsprechen herkömmlichen Strukturierungs- und Ätzverfahren, wobei vorzugsweise anisotrope Ätzverfahren durchgeführt werden.

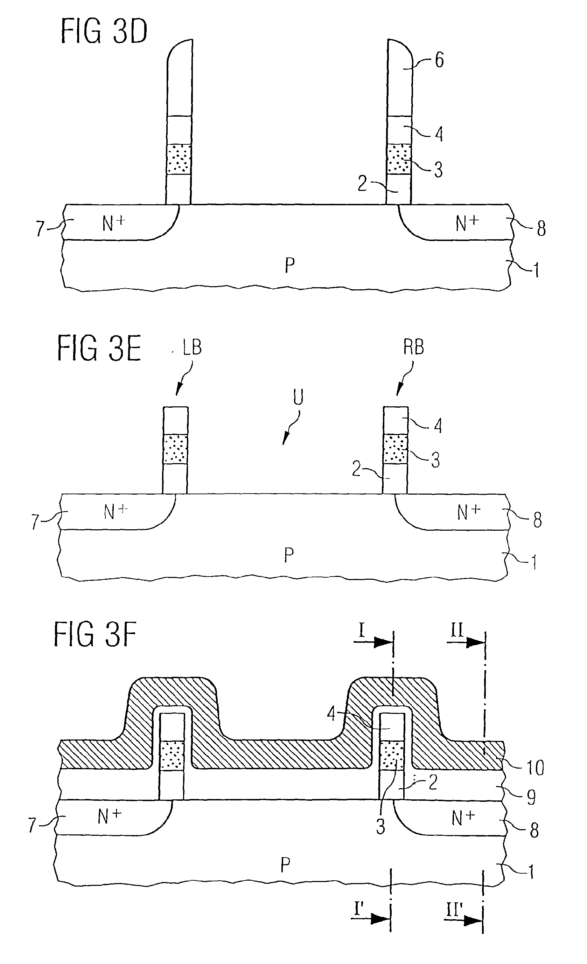

Gemäß Figur 3D werden in einem nachfolgenden Verfahrensschritt die verbleibende Maskenschicht 5 sowie die zweite Isolationsschicht 4, die Ladungsspeicherschicht 3 und die erste Isolationsschicht 2 unter Verwendung der Seitenwandschichten bzw. Spacer 6 entfernt. Wiederum wird hierbei vorzugsweise anisotropes Ätzen (RIE, reactive ion etching) durchgeführt, wobei sich jedoch eine gewisse Dünnung des Substrats in den Source- und Draingebieten 7 und 8 ergeben kann. Diese Dünnung des Substrats 1 durch den Rückätzprozess ist jedoch generell vernachlässigbar, da sie keine negativen Auswirkungen auf die elektrischen oder sonstigen Eigenschaften des Prozesses oder der somit hergestellten Speicherzelle verursacht. Auf diese Weise erhält man eine Unterbrechung bzw. Lücke U zum Ausbilden von lokal begrenzten Speicherorten LB und RB, die im Wesentlichen selbstjustierend source- und drainseitig jeweils am Kanalende angeordnet sind. Die Breite dieser lokal begrenzten Speicherorte kann sehr genau durch die verwendete Spacertechnik zum Ausbilden der Seitenwandschichten 6 eingestellt werden, wodurch auch in einem sub-µm-bzw. sub-100nm-Bereich diese Speicherorte exakt definiert und angeordnet werden können. Dadurch können insbesondere die elektrischen Eigenschaften der Speicherzelle bei hoher Miniaturisierung stark verbessert werden.

Gemäß Figur 3E wird in einem nachfolgenden Verfahrensschritt die Seitenwandschicht bzw. der Spacer 6 entfernt, wobei beispielsweise herkömmliche selektive Nassätzverfahren eingesetzt werden. Im Beispiel eines Si₃N₄-Spacers 6 kann heiße Phoshorsäure dazu verwendet werden.

Gemäß Figur 3F werden in einem nachfolgenden Verfahrensschritt eine dritte Isolationsschicht 9, die im Wesentlichen eine Gateoxidschicht darstellt und beispielsweise aus thermisch ausgebildetem SiO₂ besteht, ganzflächig ausgebildet. Auf diese Wiese erhalten die Schichtstapel an den lokal begrenzten Speicherorten auch eine ausreichende Seitenwandisolation. Vorzugsweise wird diese Seitenwandisolation wiederum auf eine Dicke eingestellt, die direktes Tunneln verhindert. Anschließend erfolgt die Ausbildung einer elektrisch leitenden Steuerschicht 10, wobei beispielsweise eine hochdotierte Polysiliziumschicht oder ein Metall abgeschieden wird. Es können jedoch auch sonstige elektrisch leitende Schichten verwendet werden wie z.B. silizierte Halbleitermaterialien.

Ferner erfolgt zu diesem Zeitpunkt eine Strukturierung der elektrisch leitenden Steuerschicht 10 zum Ausbilden von Wortleitungen bzw. Wortleitungsstreifen WL.

Die Figuren 3F-I und Figur 3F-II zeigen vereinfachte Schnittansichten der in Figur 3F angedeuteten Schnitte I-I' und II-II' zur Veranschaulichung der Schichtstruktur nach diesem Strukturierungsschritt.

Gemäß Figur 3F-I befinden sich nunmehr parallel angeordnete Wortleitungen WL an der Oberfläche der abgeschiedenen oder durch thermische Oxidation ausgebildeten dritten Isolationsschicht 9, die sich wiederum auf dem aus der ersten Isolationsschicht 2, der Ladungsspeicherschicht 3 und der zweiten Isolationsschicht 4 bestehenden Schichtstapel auf dem Halbleitersubstrat 1 befindet.

Andererseits befinden sich die strukturierten und parallel verlaufenden Wortleitungen WL gemäß Figur 3F-II zwar wiederum auf der dritten Isolationsschicht 9, wobei sich jedoch diese unmittelbar auf dem jeweiligen Source- und Draingebiet 7 und 8 bzw. dem Substrat 1 befindet.

Gemäß Figur 3G erfolgt in einem weiteren Verfahrensschritt unter Verwendung der strukturierten Steuerschicht 10 bzw. der Wortleitungen WL ein selektives Entfernen der dritten Isolationsschicht 9, der zweiten Isolationsschicht 4, der Ladungsspeicherschicht 3 und der ersten Isolationsschicht 2, wodurch die bisher streifenförmig ausgebildeten lokal begrenzten Speicherorte nunmehr auch in dieser Richtung begrenzt werden. Somit ergeben sich lokal begrenzte Inseln für die Speicherorte LB und RB. Insbesondere bei einer matrixförmigen Anordnung der Speicherzellen ergibt sich somit auch eine vollständige Isolation zu benachbarten Speicherorten. Beispielsweise wird hierbei wieder ein anisotropes Ätzverfahren verwendet, wobei abschließend eine vierte Isolationsschicht 11 insbesondere zur seitlichen Isolation auch in dieser Richtung ausgebildet wird. Diese als Postoxid (POX) bezeichnete vierte Isolationsschicht 11 besitzt wiederum vorzugsweise eine Schichtdicke, welche ein direktes Tunneln verhindert.

In Figur 3G-I und Figur 3G-II sind wiederum die entsprechenden Schnittansichten I-I' und II-II' der Figur 3G dargestellt. Auf diese Weise erhält man folglich lokal begrenzte Speicherorte LB und RB, die in Form von Inseln über die jeweiligen Verfahrensschritte auf einfache Art und Weise sehr exakt definiert und angeordnet werden können, wodurch insbesondere ein Drift- und Diffusionsverhalten von eingebrachten Ladungen wesentlich beeinflusst werden kann. Insbesondere können die eingebrachten Ladungsträger nunmehr nicht länger von einem Kanalende zum anderen Kanalende wandern, wodurch eine unbeabsichtigte Veränderung der Schwellwertspannungen in der Speicherzelle verhindert wird. Darüber hinaus erhält man ein verbessertes Programmierverhalten, da eine Rekombination (Kompensation) von positiven und negativen Ladungen auf diesem sehr begrenztem Raum wesentlich schneller erfolgt. Insbesondere bei Verwendung des sogenannten "silicon rich oxide" (SRO) kann darüber hinaus durch Einstellung des Si-Anteils die Beweglichkeit der Ladungsträger in der Ladungsspeicherschicht 3 eingestellt werden, wodurch man auch eine laterale Leitfähigkeit innerhalb der lokal begrenzten Speicherorte definiert einstellen kann. Bei Verwendung von Si₃N₄ erfolgt eine derartige Einstellung der Beweglichkeit der Ladungsträger in der Ladungsspeicherschicht 3 unmittelbar durch den gewählten Abscheideprozess.

Ferner ist auf Grund der selbstjustierenden Prozesse diese Speicherzelle auch für sehr feine Strukturen geeignet, wobei sie nur geringe Anforderungen an eine nicht dargestellte Auswerteschaltung stellt.

Die Erfindung wurde vorstehend anhand von Silizium-Halbleitermaterialien beschrieben. Sie ist jedoch nicht darauf beschränkt und umfasst in gleicher Weise auch alternative Halbleitermaterialien. In gleicher Weise können auch andere ladungsspeichernde oder isolierende Schichten und alternative Dotierungen verwendet werden.

## Patentansprüche

1. Verfahren zur Herstellung einer nichtflüchtigen Halbleiter-Speicherzelle mit den Schritten:
a) Ausbilden einer ersten Isolationsschicht (2), einer elektrisch nicht leitenden Ladungsspeicherschicht (3), einer zweiten Isolationsschicht (4) und einer Maskenschicht (5) auf einem Substrat (1);
b) Strukturieren der Maskenschicht (5);
c) Ausbilden von Seitenwandschichten (6) an der strukturieren Maskenschicht (5);
d) Entfernen von zumindest der zweiten Isolationsschicht (4) und der Ladungsspeicherschicht (3) unter Verwendung der strukturierten Maskenschicht (5) und der Seitenwandschicht (6);
e) Ausbilden von Source- und Draingebieten (7, 8) im Substrat (1);
f) Entfernen der Maskenschicht (5);
g) Entfernen der zweiten Isolationsschicht (4), der Ladungsspeicherschicht (3) und der ersten Isolationsschicht (2) unter Verwendung der Seitenwandschichten (6) zum Erzeugen von lokal begrenzten Schichtstapeln;
h) Entfernen der Seitenwandschichten (6);
i) Ausbilden einer dritten Isolationsschicht (9) an der Oberfläche des Substrats (1) und den Schichtstapeln;
j) Ausbilden einer elektrisch leitenden Steuerschicht (10);
k) Strukturieren der Steuerschicht (10) zum Ausbilden von Wortleitungen (WL); und
l) Entfernen der dritten Isolationsschicht (9), der zweiten Isolationsschicht (4), der Ladungsspeicherschicht (3) und der ersten Isolationsschicht (2) unter Verwendung der strukturierten Steuerschicht (10) zum Ausbilden von lokal begrenzten Speicherorten (LB, RB).

2. Verfahren nach Patentanspruch 1, **gekennzeichnet durch** den Schritt m) Ausbilden einer vierten Isolationsschicht (11).

3. Verfahren nach einem der Patentansprüche 1 oder 2, **dadurch gekennzeichnet, dass** in Schritt d), f), g) und/oder l) ein anisotropes Ätzen durchgeführt wird.

4. Verfahren nach einem der Patentansprüche 1 bis 3, **dadurch gekennzeichnet, dass** in Schritt h) ein Nassätzen durchgeführt wird.

5. Verfahren nach einem der Patentansprüche 1 bis 4, **dadurch gekennzeichnet, dass** in Schritt e) eine Ionenimplantation unter Verwendung der ersten Isolationsschicht (2) als Streumaterial verwendet wird und anschließend die erste Isolationsschicht (2) entfernt wird.

6. Verfahren nach einem der Patentansprüche 1 bis 4, **dadurch gekennzeichnet, dass** in Schritt d) ferner die erste Isolationsschicht (2) entfernt wird; und
in Schritt e) eine Ionenimplantation unmittelbar in das Substrat (1) durchgeführt wird.

7. Verfahren nach einem der Patentansprüche 1 bis 6, **dadurch gekennzeichnet, dass** die erste, zweite, dritte und/oder vierte Isolationsschicht (2, 4, 9, 11) SiO₂ aufweist.

8. Verfahren nach einem der Patentansprüche 1 bis 7,
**dadurch gekennzeichnet, dass** die elektrisch nicht leitende Ladungsspeicherschicht (3) SiₓO_{y} oder Si₃N₄ aufweist.

9. Verfahren nach einem der Patentansprüche 1 bis 8, **dadurch gekennzeichnet, dass** die Steuerschicht (10) und/oder die Maskenschicht (5) dotiertes PolySilizium, ein Metall und/oder silizidiertes Halbleitermaterial aufweisen.

10. Verfahren nach einem der Patentansprüche 1 bis 9, **dadurch gekennzeichnet, dass** das Substrat (1) Si aufweist.

## Claims

1. Method for fabricating a nonvolatile semiconductor memory cell having the following steps:
a) formation of a first insulation layer (2), an electrically non-conductive charge storage layer (3), a second insulation layer (4) and a mask layer (5) on a substrate (1);
b) patterning of the mask layer (5);
c) formation of sidewall layers (6) at the patterned mask layer (5);
d) removal of at least the second insulation layer (4) and the charge storage layer (3) using the patterned mask layer (5) and the sidewall layer (6) ;
e) formation of source and drain regions (7, 8) in the substrate (1);
f) removal of the mask layer (5);
g) removal of the second insulation layer (4), the charge storage layer (3) and the first insulation layer (2) using the sidewall layers (6) in order to produce locally delimited layer stacks;
h) removal of the sidewall layers (6);
i) formation of a third insulation layer (9) at the surface of the substrate (1) and the layer stacks;
j) formation of an electrically conductive control layer (10);
k) patterning of the control layer (10) in order to form word lines (WL); and
l) removal of the third insulation layer (9), the second insulation layer (4), the charge storage layer (3) and the first insulation layer (2) using the patterned control layer (10) in order to form locally delimited memory locations (LB, RB).

2. Method according to Patent Claim 1,
**characterized by** the following step m) formation of a fourth insulation layer (11).

3. Method according to either of Patent Claims 1 and 2,
**characterized in that** an anisotropic etching is carried out in step d), f), g) and/or 1).

4. Method according to one of Patent Claims 1 to 3, **characterized in that** a wet etching is carried out in step h).

5. Method according to one of Patent Claims 1 to 4, **characterized in that**, in step e), an ion implantation using the first insulation layer (2) as screen material is used and the first insulation layer (2) is subsequently removed (10).

6. Method according to one of Patent Claims 1 to 4, **characterized in that**
in step d), the first insulation layer (2) is furthermore removed; and
in step e), an ion implantation is carried out directly into the substrate (1).

7. Method according to one of Patent Claims 1 to 6, **characterized in that** the first, second, third and/or fourth insulation layer (2, 4, 9, 11) has SiO₂.

8. Method according to one of Patent Claims 1 to 7, **characterized in that** the electrically non-conductive charge storage layer (3) has SiₓO_{y} or Si₃N₄.

9. Method according to one of Patent Claims 1 to 8, **characterized in that** the control layer (10) and/or the mask layer (5) has doped polysilicon, a metal and/or silicided semiconductor material.

10. Method according to one of Patent Claims 1 to 9, **characterized in that** the substrate (1) has Si.

## Revendications

1. Procédé de production d'une cellule de mémoire à semiconducteur non volatile, comprenant les stades dans lesquels :
a) on forme une première couche (2) isolante, une couche (3) non conductrice de l'électricité formant accumulateur de charge, une deuxième couche (4) isolante et une couche (5) de masque sur un substrat (1) ;
b) on structure la couche (5) de masque ;
c) on forme des couches (6) de paroi latérale sur la couche (5) de masque structurée ;
d) on élimine au moins la deuxième couche (4) isolante et la couche (3) formant accumulateur de charge en utilisant la couche (5) de masque structurée et la couche (6) de paroi latérale ;
e) on forme des zones (7, 8) de source et de drain dans le substrat (1) ;
f) on élimine la couche (5) de masque ;
g) on élimine la deuxième couche (4) isolante, la couche (3) formant accumulateur de charge et la première couche (2) isolante en utilisant les couches (6) de paroi latérale, pour produire des piles de couches délimitées localement ;
h) en élimine les couches (6) de paroi latérale ;
i) on forme une troisième couche (9) isolante à la surface du substrat (1) et de la pile de couches ;
j) on forme une couche (10) de commande conductrice de l'électricité ;
k) on structure la couche (10) de commande pour former des lignes (WL) de mots ; et
l) on élimine la troisième couche (9) isolante, la deuxième couche (4) isolante, la couche (3) formant accumulateur de charge et la première couche (2) isolante en utilisant la couche (10) de commande structurée pour former des emplacements (LB, RB) de mémoire délimités localement.

2. Procédé suivant la revendication 1,
**caractérisé par** le stade dans lequel
m) on forme une quatrième couche (11) isolante.

3. Procédé suivant l'une des revendications 1 ou 2, **caractérisé en ce que** dans le stade d), f), g) et/ou 1), on effectue une attaque anisotrope.

4. Procédé suivant l'une des revendications 1 à 3, **caractérisé en ce que**, au stade h), on effectue une attaque en voie humide.

5. Procédé suivant l'une des revendications 1 à 4, **caractérisé en ce que**, au stade e), on utilise une implantation d'ions en utilisant la première couche (2) isolante comme matière de diffusion et on élimine ensuite la première couche (2) isolante.

6. Procédé suivant l'une des revendications 1 à 4, **caractérisé en ce que**, au stade d), on élimine, en outre, la première couche (2) isolante ; et
au stade e), on effectue une implantation d'ions directement dans le substrat (1).

7. Procédé suivant l'une des revendications 1 à 6, **caractérisé en ce que** la première, deuxième, troisième et/ou quatrième couche (2, 4, 9, 11) isolante comprend du SiO₂.

8. Procédé suivant l'une des revendications 1 à 7, **caractérisé en ce que** la couche (3) non conductrice de l'électricité formant accumulateur de charge comprend du SiₓO_{y} ou du Si₃N₄.

9. Procédé suivant l'une des revendications 1 à 8, **caractérisé en ce que** la couche (10) de commande et/ou la couche (5) de masque comprend du polysilicium dopé, un métal et/ou une matière semiconductrice siliciurée.

10. Procédé suivant l'une des revendications 1 à 9, **caractérisé en ce que** le substrat (1) comprend du Si.
